# EUROPEAN PATENT SPECIFICATION

(11) **EP 0 547 676 B1**
(45) Date of publication and mention of the grant of the patent: **18.06.1997**
(21) Application number: 92203822.9
(22) Date of filing: 09.12.1992
(51) Int. Cl.: H01L 27/102, H01L 27/07

(54) **Semiconductor device with a memory cell**
Halbleiteranordnung mit Speicherzelle
Dispositif semiconducteur muni d'une cellule de mémoire

(30) Priority: 16.12.1991 EP 91203306
(43) Date of publication of application: 23.06.1993
(73) Proprietor: Philips Electronics N.V., 5621 BA Eindhoven (NL)
(72) Inventor: Sankaranarayanan, Lakshmi Narayanan, NL-5656 AA Eindhoven (NL); Slotboom, Jan willem, NL-5656 AA Eindhoven (NL); Van der Sijde, Arjen Gerben, NL-5656 AA Eindhoven (NL)
(74) Representative: Houbiers, Ernest Emile Marie Gerlach

(56) References cited:
- EP-A- 0 071 042
- DE-A- 4 006 432
- US-A- 3 401 319

## Description

The invention relates a semiconductor body with a programmable memory cell which comprises a bipolar transistor with an emitter region and a collector region of a first conductivity type mutually separated by a base region of a second, opposite conductivity type, the emitter region being coupled to a first supply line and the collector region to a second supply line, while the base region is connected through a control transistor in order to provide the bipolar transistor with a base current at least temporarily during operation, the collector region being connected to the second supply line through a load, the control transistor comprising a field effect transistor having a source zone and a drain zone of the second conductivity type which are mutually separated by a channel region, said source zone, drain zone adjoining the collector region, said channel region being situated within the collector region, the channel region being separated from a gate electrode by a dielectric layer, the drain zone together with the base region being formed by a common semiconductor zone of the second conductivity type.

Such a device is know e.g. from US-A-3,401,319. In this known cell, the source zone, drain zone and channel region of the control transistor are provided within a collector region in the form of a lateral field-effect transistor.

The invention has for its object *inter alia* to provide a device of the kind mentioned in the opening paragraph with a memory cell which has a considerably smaller area than the known memory cell.

According to the invention, a device of the kind mentioned in the opening paragraph is for this purpose characterized in that the device comprises a similar further memory cell, in that the two memory cells comprise a collector region adjoining the surface and situated on a buried layer of the second conductivity type, which buried layer forms the base region, in that the buried layer is situated on an emitter region of the first conductivity type common to both cells, and in that the cells are mutually separated by a groove which extends from the surface at least to the emitter region and in which a gate electrode is provided which is common to both cells.

The invention will now be explained in more detail with reference to a drawing, in which
Fig. 1 is a cross-section of a device according to the prior art;
Fig. 2 is an equivalent circuit diagram of the device of Fig. 1;
Fig. 3 shows the collector current as a function of the collector voltage for various gate voltages in the device of Fig. 1;
Fig. 4 shows the collector current as a function of the gate voltage in the device of Fig. 1; and
Fig. 5 is a cross-section of a device according to the invention.

The Figures are purely diagrammatic and not drawn to scale. Some dimensions are particularly strongly exaggerated for greater clarity. Semiconductor regions of the same conductivity type are hatched in the same direction as much as possible, and corresponding parts are given the same reference numerals.

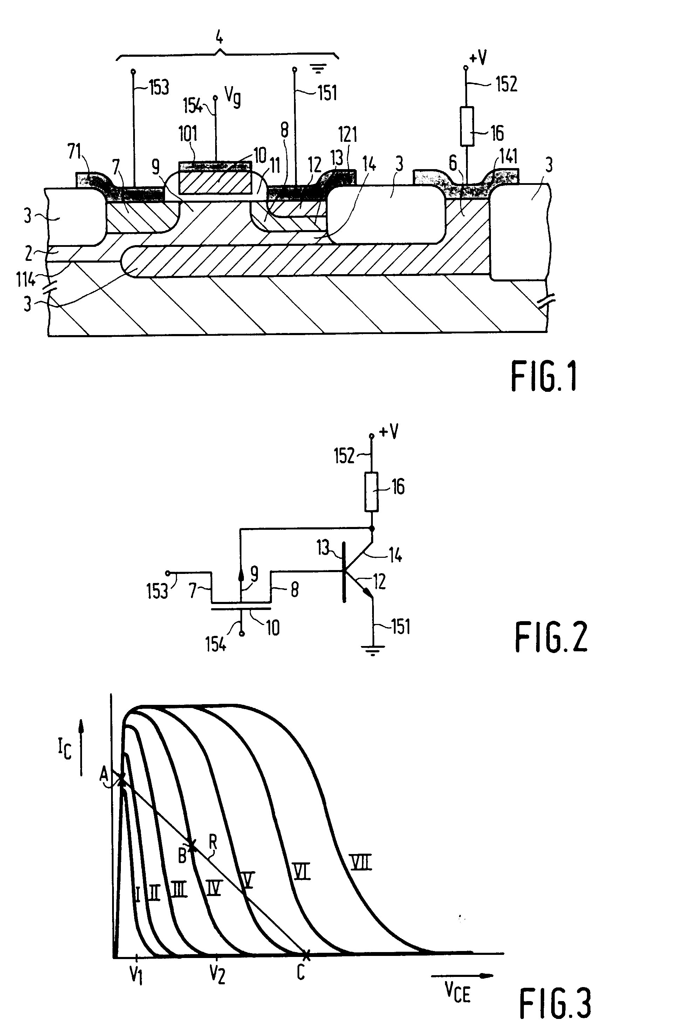

The device of Fig. 1 comprises an n-type epitaxial layer 2 provided on a p-type silicon substrate 1. A partly recessed field insulation pattern 3 of silicon oxide, laterally bounding an island region 4, is provided in the epitaxial layer. Below the island region 4 there is a comparatively heavily doped n-type buried layer 5. The buried layer 5 lies at an interface between the substrate 1 and the epitaxial layer 2 and provides a low-ohmic connection between the island region 4 and a contact zone 6 adjoining the surface.

The memory cell is provided in the island region 5. The memory cell comprises a MOS transistor with a p-type source zone 7 and drain zone 8, separated from one another by a channel zone 9. The source zone 7 is provided with a low-ohmic contact 71 of aluminium at the surface. A gate electrode 10 of n-type silicon is provided over the channel region 9 and insulated from the channel region 9 by a thin gate dielectric 11, in this example an approximately 100 nm thick silicon oxide layer. The conductance in the channel region 9 can be controlled by means of the gate electrode 10. For this purpose, the gate electrode is connected to a diagrammatically indicated control line 154 through an aluminium gate contact 101.

The memory cell further comprises a bipolar transistor, in this example in the form of a vertical NPN transistor which is integrated with the MOS transistor so as to save space. The bipolar transistor comprises an n-type emitter region 12 which is provided in the drain zone 8 of the MOS transistor and is provided with an aluminium emitter contact 121. The drain zone 8 itself forms a p-type base region 13 which separates the emitter region 12 from an n-type collector region 14 which is formed by the island region 4 and is thus integral with the channel region 9 of the MOS transistor. The collector region 14 is laterally insulated by means of the insulation pattern 3. The insulation of the collector region 14 from the p-type substrate 1 is provided by a pn-junction 114 which is blocked during operation.

The emitter region 12 is connected through the emitter contact 121 to a first supply line 151 which is provided with a fixed voltage, in this case earth. The base region 13 can be supplied through the MOS transistor from a third supply line 153 to which the source zone 7 of the MOS transistor is connected. The collector region 14 is coupled to a second supply line 152, which is also kept at an at least substantially constant voltage, through a load 16, in this example an ohmic resistance of approximately 1 GΩ. In the present example, the voltage of the second supply line is approximately 1,5 V. The buried layer 5 and the contact zone 6 in this case ensure the electrical conduction between the collector region 14 and the collector contact 141. An equivalent circuit diagram of the memory cell is shown in Fig. 2.

If a sufficient negative control voltage is applied to the gate electrode 10, an inversion channel will be formed below the gate electrode 10 in the channel region 9, so that the MOS transistor becomes conducting. The base region 13 is then supplied with a base current by which the bipolar transistor is also switched on. The (collector) current through the bipolar transistor causes a voltage drop across the load 16. When the voltage of the collector region 14, and thus of the island region 5 increases holes are driven from the inversion channel and the conduction through the MOS transistor is gradually pinched off in proportion as the collector voltage rises further. This feedback from the collector region 14 to the MOS transistor eventually has the result that the bipolar transistor receives a lower base current with an increasing emitter-collector voltage, so that the collector current decreases again. In Fig. 3, the curves I-VII diagrammatically show the change in collector current I_{c} as a function of the emitter-collector voltage V_{CE} for a number of different gate voltages. The curve I here corresponds to a positive gate voltage, and the curve VII to a negative gate voltage, the gate voltage decreasing stepwise in the intermediate curves. Starting from curve III, the transistor exhibits the negative resistance characteristics described above in the voltage domain from V₁ to V₂.

The straight line **R** diagrammatically indicates the current-voltage characteristic of the resistor 16 which is connected in series with the collector region 14. The series circuit of the two elements has the result that there are only three discrete states in which the system can find itself. These states are given by the points of intersection **A, B** and **C** of the two characteristics. Of these states, only **A** and **C** are stable. State **B** is unstable; a minute disturbance of state **B** has the result that the system will immediately switch to one of the stable states **A** and **C**. This means that the memory cell will be either in state **A** or in state **B** during operation.

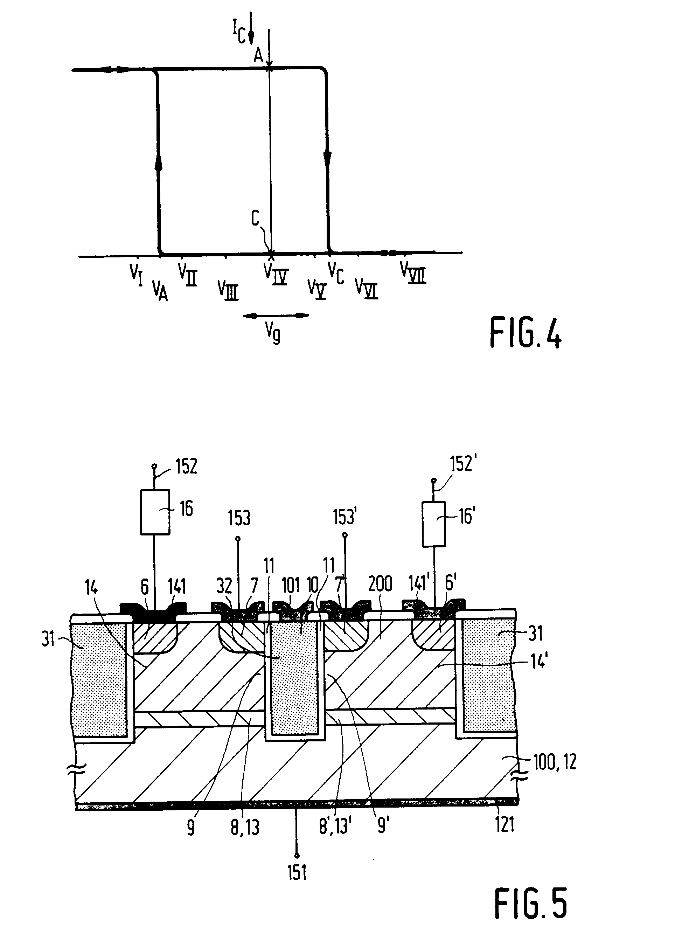

The memory cell is programmed in that it is brought into either of the two states. This can be achieved by increasing or decreasing the gate voltage. When the voltage is increased, starting from curve IV which corresponds to a gate voltage of 0 V, the current-voltage characteristic of the cell is shifted in the direction of the curves III-I. For a given gate voltage V_{G}, the characteristic no longer has state **A** in common with the resistor characteristic **R**. The cell then has no option but to adopt state **C**. When on the other hand the gate voltage is decreased, the current-voltage characteristic of the cell shifts in the direction of the curves V-VII. For a given gate voltage V_{A}, state **C** is no longer shared by the transistor and the resistor in that case, so that the cell is forced to assume state **A**. When the gate voltage is brought to 0 V again, the cell remains in the programmed state **A** or **C**, although the cell is no longer provided with an external base current. Fig. 4 shows the collector current I_{C} as a function of the gate voltage V_{G}. The gate voltages corresponding to the curves I-VII are denoted with V_{I}-V_{VII,} respectively.

It will be clear that the cell dissipates the highest power in state **A**. But even in state **A**, the power dissipation of the memory cell according to the invention is considerably lower than that of the known memory cell. The memory cell described here supplies a collector current of approximately 1.5 nA in state **A**, which leads to a power dissipation of approximately 3,75 nW at a supply voltage of 2.5 V. The power consumption of the memory cell may be further reduced through a reduction of the emitter surface area. Given a minimum lithographical dimension of 1 µm, as in the known device, the cell according to the invention may be constructed with an emitter surface of approximately 1 µm², in which case the cell would consume less than 25 pA. This device, therefore, is eminently suitable for battery powered applications, for example, electronic credit cards and portable electronic units.

The collector region 14 is connected to readout means (not shown) for determining the potential of the collector region 14 relative to the emitter region 12. The state in which the memory cell is stabilized can be read out in this manner. Alternatively, however, any other fixed reference voltage may be chosen instead of the emitter potential relative to which the collector potential is determined. It is also possible to use the collector current instead of the collector voltage as an indication of the instantaneous memory state of the cell.

A device according to the invention is shown in Fig. 5. The device shown comprises an n-type silicon substrate on which an n-type epitaxial layer 200 is provided. The epitaxial layer 200 is divided into islands by means of grooves, in which islands separate memory cells are provided. Two such cells are shown in the Figure. As in the preceding example, the memory cell comprises a bipolar transistor whose base region is controlled by a PMOS transistor.

The bipolar transistor in the present example is formed by an n-type collector region 14, 14' which is situated at the surface and which is separated from the n-type substrate 100 by a buried base region 13, 13'. The base region is formed here by a p-type buried layer which lies at an interface between the substrate 100 and the epitaxial layer 200. The buried layer at the same time forms a buried drain zone 8, 8' of the PMOS control transistor. The substrate 100 forms an emitter region 12, 12' which is common to both cells and is provided with an emitter contact 121 at the lower side. The substrate 100 is connected to a first supply line 151 through the emitter contact 121.

The collector region 14, 14' is formed by an island of the n-type epitaxial layer 200 and is provided with a comparatively heavily doped contact zone 6, 6' at the surface. A collector contact is provided on the contact zone 6, 6' by which contact the collector region 14, 14' according to the invention is coupled to a second supply line 152, 152' through a load 16, 16'.

The n-type island at the same time forms a channel region 9, 9' of the PMOS transistor, separating the buried drain zone 8, 8' from a p-type source zone 7, 7' situated at the surface. The conductivity of the MOS transistor which is vertically integrated in this way can be controlled with a gate electrode 10 which is provided in the groove 32 between the two memory cells. The groove wall is previously provided with a thin insulating layer 11 of silicon oxide by which the gate electrode 10 is insulated from the channel region 9, 9'. In the present example, p-type polycrystalline silicon is used for the gate electrode, which is found to fill up the groove satisfactorily. Such filled grooves 31 provide lateral insulation for the memory cells elsewhere.

A fixed potential difference is applied between the first and the second supply line 151, 152. A cell can then be programmed in that a suitable voltage sweep is offered to the gate electrode 10, as described for the device of Fig. 1. The source zones 7, 7' of the two cells are each connected to their own further supply line 153, 153', from which a base current can be supplied to the base regions 13, 13', respectively. The memory cell to be programmed can be selected by applying a voltage or not to the further supply line 153, 153'.

The operation of the embodiment of the device described here does not differ essentially from that of the device of Fig. 1. The present embodiment of the device, however, is integrated in a more efficient manner. The surface area required for the device in this embodiment is approximately 8 ℓ² µm² per memory cell, ℓ being the smallest achievable lithographic dimension in micrometers. The device in this case requires no more or hardly more space than does the known device, while the power consumption is considerably reduced.

It should be noted that the device according to the invention need not necessarily be operated at an extremely low current level. The device also functions with a collector current which is higher by a few orders of magnitude. It is true that the power consumption is greater when the collector current is greater, but this is counterbalanced by the fact that the access time for the memory cell can be much shorter. If the bipolar transistor is connected in series with a variable load and the load is provided with switching means for switching the load between a comparatively high and a comparatively low value, both aspects can be utilized. The variable load in that case is switched to a high level as long as the information contents of the cell need only be stored. The collector current, and therefore the power consumption of the cell are low in that case. The moment the memory cell is addressed so as to be programmed or read, however, the load is switched to a comparatively low value, so that a greater access speed is obtained. Such a switchable load may be formed, for example, by a first resistor connected in parallel to a second resistor in series with a switching transistor.

Although the invention was explained with reference to one embodiment, it will be obvious that the invention is by no means limited to the examples given. Many more variations are possible within the scope of the invention, which is defined by the claim. Thus the conductivity types specified may all be simultaneously replaced by their opposites.

Furthermore, so-called growing and doping techniques, such as molecular beam epitaxy (MBE) and so-called delta doping may be used for manufacturing the device according to the invention. Especially the embodiment of Fig. 5 is advantageously realised by means of MBE, in which case a doped SiGe layer or a layer of another contrasting semiconductor material having a sharply defined hetero-pn-junction is used instead of the buried layer which forms the base of the bipolar transistor, so that the amplification factor of the bipolar transistor reaches a comparatively high value.

In general terms, the invention supplies a semiconductor device provided with a memory cell whose power consumption during operation is comparatively low and with which a high packing density can be realised.

## Claims

1. A semiconductor device comprising a semiconductor body with a programmable memory cell which comprises a bipolar transistor with an emitter region (12) and a collector region (14) of a first conductivity type mutually separated by a base region (8) of a second, opposite conductivity type, the emitter region being connected to a first supply line (151), the collector region being connected through a load (16) to a second supply line (152), while the base region is connected to a third supply line (153) through a control transistor in order to provide the bipolar transistor with a base current at least temporarily during operation, the control transistor comprising a field effect transistor having a source zone (7) and a drain zone (13) of the second conductivity type which are mutually separated by a channel region (9), said source zone, and drain zone adjoining the collector region, said channel region being situated within the collector region, the channel region being separated from a gate electrode (10) by a dielectric layer (11), the drain zone together with the base region being formed by a common semiconductor zone of the second conductivity type, characterized in that the device comprises a similar further memory cell; in that said common semiconductor zone is a buried layer (13) of the second conductivity type, said buried layer forming the respective base regions; in that the buried layer is situated on said emitter region (100, 12) of the first conductivity type, said emitter region being common to both cells; in that said collector region (14, 14') of each memory cell is laterally insulated and is situated on said buried layer (13); and in that the cells are mutually separated by a groove which extends from the surface to at least the emitter region and in which said gate electrode is provided, said gate electrode being common to both cells.

## Patentansprüche

1. Halbleiteranordnung mit einem Halbleiterkörper, welcher eine programmierbare Speicherzelle vorsieht, welche einen Bipolartransistor mit einer Emitterzone (12) und einer Kollektorzone (14) eines ersten Leitfähigkeitstypes aufweist, welche durch eine Basiszone (8) eines zweiten, entgegengesetzten Leitfähigkeitstypes voneinander getrennt sind, wobei die Emitterzone mit einer ersten Versorgungsleitung (151), die Kollektorzone über eine Last (16) mit einer zweiten Versorgungsleitung (152) verbunden ist, wohingegen die Basiszone über einen Regeltransistor an eine dritte Versorgungsleitung (153) angeschlossen ist, um den Bipolartransistor bei Betrieb zumindest zeitweilig mit einem Basisstrom zu versorgen, wobei der Regeltransistor einen Feldeffekttransistor mit einer Sourcezone (7) und einer Drainzone (13) des zweiten Leitfähigkeitstypes aufweist, welche durch eine Kanalzone (9) voneinander getrennt sind, wobei Sourcezone und Drainzone an die Kollektorzone angrenzen, die Kanalzone in der Kollektorzone angeordnet und durch eine dielektrische Schicht (11) von einer Gateelektrode (10) getrennt ist, die Drainzone und die Basiszone von einer gemeinsamen Halbleiterzone des zweiten Leitfähigkeitstypes gebildet werden, dadurch gekennzeichnet, daß die Anordnung eine ähnliche, weitere Speicherzelle aufweist, daß es sich bei der gemeinsamen Halbleiterzone um eine vergrabene Schicht (13) des zweiten Leitfähigkeitstypes handelt, wobei diese die jeweilige Basiszone bildet, daß die vergrabene Schicht auf der Emitterzone (100, 12) des ersten Leitfähigkeitstypes angeordnet ist, wobei die Emitterzone für beide Zellen gemeinsam vorgesehen ist, daß die Kollektorzone (14, 14) jeder Speicherzelle lateral isoliert und auf der vergrabenen Schicht (13) vorgesehen ist, und daß die Zellen durch eine Vertiefung, welche sich von der Oberfläche zumindest zu der Emitterzone erstreckt und in welcher die Gateelektrode angeordnet ist, wobei die Gateelektrode für beide Zellen gemeinsam vorgesehen ist, voneinander getrennt sind.

## Revendications

1. Dispositif semiconducteur comprenant un corps semiconducteur muni d'une cellule de mémoire programmable, qui comprend un transistor bipolaire muni d'une région d'émetteur (12) et d'une région de collecteur (14) d'un premier type de conductivité, qui sont séparées l'une de l'autre par une région de base (8) d'un deuxième type de conductivité opposé, la région d'émetteur étant connectée à une première ligne d'alimentation (151), la région de collecteur étant connectée par l'intermédiaire d'une charge 16 à une deuxième ligne d'alimentation (152), alors que la région de base est connectée à une troisième ligne d'alimentation (153) par l'intermédiaire d'un transistor de commande afin de munir le transistor bipolaire d'un courant de base au moins temporairement pendant le fonctionnement, le transistor de commande comprenant un transistor à effet de champ présentant une zone de source (7) et une zone de drain (13) du deuxième type de conductivité qui sont mutuellement séparées par une région de canal (9), ladite zone de source et ladite zone de drain avoisinant la région de collecteur, ladite région de canal étant située dans la région de collecteur, la région de canal étant séparée d'une électrode de porte (10) par une couche diélectrique (11), la région de drain ensemble avec la région de base étant formée par une zone semiconductrice commune du deuxième type de conductivité, caractérisé en ce que le dispositif comprend une autre cellule de mémoire analogue; en ce que ladite zone semiconductrice commune est une couche enterrée (13) du deuxième type de conductivité, ladite couche enterrée constituant les régions de base respectives; en ce que la couche enterrée est située sur ladite région d'émetteur (100,12) du premier type de conductivité, ladite région d'émetteur étant commune aux deux cellules; en ce que ladite région de collecteur (14,14') de chaque cellule de mémoire est latéralement isolée et est située sur ladite couche enterrée (13); et en ce que les cellules sont mutuellement séparées par une rainure qui s'étend à partir de la surface au moins jusqu'à la région d'émetteur et dans laquelle est disposée ladite électrode de porte, ladite électrode de porte étant commune aux deux cellules.
